(19) Europäisches Patentamt
European Patent Office
Office européen des brevets

(11) EP 1 736 500 A1

(12) # EUROPEAN PATENT APPLICATION
published in accordance with Art. 158(3) EPC

(43) Date of publication:
**27.12.2006 Bulletin 2006/52**

(21) Application number: **05734362.6**

(22) Date of filing: **13.04.2005**

(51) Int Cl.:
***C08G 77/14*** *(2006.01)* ***C08G 59/20*** *(2006.01)*
***C08G 59/42*** *(2006.01)* ***H01L 23/29*** *(2006.01)*
***H01L 23/31*** *(2006.01)*

(86) International application number:
**PCT/JP2005/007493**

(87) International publication number:
**WO 2005/100445 (27.10.2005 Gazette 2005/43)**

(84) Designated Contracting States:
**DE**

(30) Priority: **16.04.2004 JP 2004121124**
**26.04.2004 JP 2004129317**
**01.10.2004 JP 2004290486**

(71) Applicant: **JSR Corporation**
**Tokyo 104-0045 (JP)**

(72) Inventors:
- **AKIIKE, Toshiyuki**
**JSR Corporation**
**Chuo-ku, Tokyo 104-0045 (JP)**
- **KAJITA, Toru**
**JSR Corporation**
**Chuo-ku, Tokyo 104-0045 (JP)**
- **YAMADA, Kinji**
**JSR Corporation**
**Chuo-ku, Tokyo 104-0045 (JP)**

(74) Representative: **TBK-Patent**
**Bavariaring 4-6**
**80336 München (DE)**

(54) **COMPOSITION FOR SEALING OPTICAL SEMICONDUCTOR, OPTICAL SEMICONDUCTOR SEALING MATERIAL, AND METHOD FOR PRODUCING COMPOSITION FOR SEALING OPTICAL SEMICONDUCTOR**

(57) A polyorganosiloxane having a weight average molecular weight of 500 to 1,000,000 obtained by heating a silane compound having an epoxy group and a silane compound having no epoxy group in the presence of an organic solvent, an organic base and water, an optical semiconductor sealing composition comprising the same as the main component, an optical semiconductor sealer and an optical semiconductor.

EP 1 736 500 A1

**Description**

TECHNICAL FIELD

The present invention relates to a composition for sealing an optical semiconductor such as a blue LED or white LED, a sealer for the optical semiconductor, and a process for preparing an optical semiconductor sealing composition used as the above sealing composition.

BACKGROUND ART

Heretofore, an epoxy compound consisting essentially of bisphenol A glycidyl ether has been commonly used as a resin for sealing an optical semiconductor. However, as this epoxy compound has an aromatic ring, its resistance to ultraviolet light (UV resistance) is unsatisfactory for sealing an optical semiconductor which emits blue light or ultraviolet light.

Then, to improve the UV resistance of the resin for sealing an optical semiconductor, use of an alicyclic epoxy compound is proposed (JP-A 2003-82062). However, it cannot be said that the alicyclic epoxy compound is satisfactory in terms of UV resistance.

Meanwhile, it is known that a resin having a siloxane skeleton has excellent weatherability, and studies on use of a resin having a polydimethysiloxane as the main skeleton as an optical semiconductor sealer are now under way vigorously. However, it is reported that the hardness of a cured product of the above resin is unsatisfactory, dust readily adheres to the cured product as it has tackiness, a gold wire used for wiring is broken by vibration, or the cured product easily peels off due to low adhesion to a substrate.

In order to improve the hardness and adhesion of the cured product, a silsesquioxane-based resin is proposed as a siloxane-based material having high hardness and adhesion. Particularly an optical semiconductor sealer obtained from a silsesquioxane-based resin having an epoxy group is disclosed by JP-A 62-106632. However, the silsesquioxane-based resin disclosed by JP-A 62-106632 cannot be put to practical use as an optical semiconductor sealer because it has the following problems. That is, when a solvent is distilled off for the pot molding of the resin, the resin gels, thereby making it difficult to mold it, and when the obtained film is thick, it may crack or foam. As means of preparing a polyorganosiloxane having an epoxy group, there is known a process in which an epoxy derivative having a vinyl group is added to a polyorganosiloxane having an Si-H bond by using a platinum, rhodium or ruthenium catalyst (JP-A 01-297421, JP-A 02-067290, JP-A 04-252228, JP-A 04-352793, JP-A 08-041168 and JP-A 12-103859). However, the polyorganosiloxane having an Si-H bond is unstable to water and difficult to handle, and its raw materials are expensive. Further, when the catalyst remains, it causes the coloring of the obtained product.

DISCLOSURE OF THE INVENTION

It is an object of the present invention which has been made in view of the above situation to provide an optical semiconductor sealing composition which can be molded by potting, is free from the cracking or foaming of a cured product obtained therefrom even when it has a large film thickness and can provide an achromatic transparent optical semiconductor sealer having excellent UV resistance and heat resistance, and a process for preparing the same.

Other objects and advantages of the present invention will become obvious from the following description.

According to the present invention, firstly, the above objects and advantages of the present invention are attained by a polyorganosiloxane having a weight average molecular weight in terms of polystyrene of 500 to 1,000,000 obtained by hydrolyzing/condensing a silane compound represented by the following formula (1) and/or a partial condensate thereof;

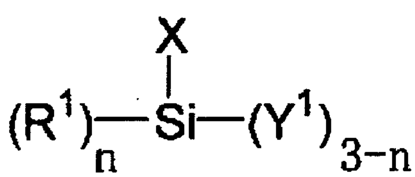

(1)

wherein X is a monovalent organic group having at least one epoxy group, $Y^1$ is a chlorine atom, bromine atom, iodine atom, or linear, branched or cyclic alkoxyl group having 1 to 20 carbon atoms, $R^1$ is a hydrogen atom, fluorine atom, linear, branched or cyclic alkyl group having 1 to 20 carbon atoms, linear, branched or cyclic substituted alkyl group

having 1 to 20 carbon atoms, linear, branched or cyclic alkenyl group having 2 to 20 carbon atoms, aryl group having 6 to 20 carbon atoms, or aralkyl group having 7 to 20 carbon atoms, and n is an integer of 0 to 2,
and a silane compound represented by the following formula (2) and/or a partial condensate thereof:

$$(R^2)_m\text{—Si—}(Y^2)_{4-m} \qquad (2)$$

wherein $Y^2$ is a chlorine atom, bromine atom, iodine atom, or linear, branched or cyclic alkoxyl group having 1 to 20 carbon atoms, $R^2$ is a hydrogen atom, fluorine atom, linear, branched or cyclic alkyl group having 1 to 20 carbon atoms, linear, branched or cyclic substituted alkyl group having 1 to 20 carbon atoms, linear, branched or cyclic alkenyl group having 2 to 20 carbon atoms, aryl group having 6 to 20 carbon atoms, or aralkyl group having 7 to 20 carbon atoms, and m is an integer of 0 to 3,
under heating in the presence of an organic solvent, an organic base and water.

According to the present invention, secondly, the above objects and advantages of the present invention are attained by a process for preparing the polyorganosiloxane of the present invention, comprising the step of hydrolyzing/condensing a silane compound represented by the above formula (1) and/or a partial condensate thereof and a silane compound represented by the above formula (2) and/or a partial condensate thereof under heating in the presence of an organic solvent, an organic base and water.

According to the present invention, thirdly, the above objects and advantages of the present invention are attained by an optical semiconductor sealing composition (may be referred to as "optical semiconductor sealing composition [I]" hereinafter) comprising:

(A) the above polyorganosiloxane which satisfies at least one of the following conditions (i) and (ii):

(i) the epoxy equivalent is 1,600 g/mol or less, and
(ii) the content of a recurring unit derived from a silane compound represented by the above formula (1) is at least 5 mol% of the total of all the recurring units; and

(B1) a carboxylic anhydride.

According to the present invention, in the fourth place, the above objects and advantages of the present invention are attained by a process for preparing the optical semiconductor sealing composition [I], comprising the step of mixing together the above polyorganosiloxane (A) and the carboxylic anhydride (B1).

According to the present invention, in the fifth place, the above objects and advantages of the present invention are attained by an optical semiconductor sealing composition (may be referred to as "semiconductor sealing composition [II]" hereinafter) comprising:

(A) the above polyorganosiloxane which satisfies at least one of the following conditions (i) and (ii):

(i) the epoxy equivalent is 1,600 g/mol or less, and
(ii) the content of a recurring unit derived from a silane compound represented by the above formula (1) is at least 5 mol% of the total of all the recurring units;

(B1) a carboxylic anhydride; and
(C) a curing accelerator.

According to the present invention, in the sixth place, the above objects and advantages of the present invention are attained by a process for preparing the semiconductor sealing composition [II], comprising the step of mixing together the above polyorganosiloxane (A), the carboxylic anhydride (B1) and the curing accelerator (C).

According to the present invention, in the seventh place, the above objects and advantages of the present invention are attained by an optical semiconductor sealing composition (may be referred to as "semiconductor sealing composition [III]" hereinafter) comprising:

(A) the above polyorganosiloxane which satisfies at least one of the following conditions (i) and (ii):

(i) the epoxy equivalent is 1,600 g/mol or less, and

(ii) the content of a recurring unit derived from a silane compound represented by the above formula (1) is at least 5 mol% of the total of all the recurring units; and

(B2) a thermal acid generator.

According to the present invention, in the eighth place, the above objects and advantages of the present invention are attained by a process for preparing the third composition of the present invention, comprising the step of mixing together the polyorganosiloxane (A) and the thermal acid generator (B2).

According to the present invention, in the ninth place, the above objects and advantages of the present invention are attained by an optical semiconductor sealer which is a cured product obtained by curing the first, second or third composition of the present invention by heating.

Finally, according to the present invention, in the tenth place, the above objects and advantages of the present invention are attained by an optical semiconductor sealed by the optical semiconductor sealer of the present invention.

## BEST MODE FOR CARRYING OUT THE INVENTION

The present invention will be described in detail hereinunder.

### Polyorganosiloxane (α) and preparation process thereof

The polyorganosiloxane (α) of the present invention is obtained by hydrolyzing/condensing a silane compound represented by the above formula (1) (to be referred to as "silane compound (1)" hereinafter) and/or a partial condensate thereof (the silane compound (1) and the partial condensate thereof may be referred to as "silane compound (1), etc." hereinafter) and a silane compound represented by the above formula (2) (to be referred to as "silane compound (2)" hereinafter) and/or a partial condensate thereof (the silane compound (2) and the partial condensate thereof may be referred to as "silane compound (2), etc." hereinafter) under heating in the presence of an organic solvent, an organic base and water.

The monovalent organic group having at least one epoxy group represented by X in the formula (1) is not particularly limited, as exemplified by γ-glycidoxypropyl group, 3,4-epoxycyclopentyl group, 3,4-epoxycyclohexyl group, (3,4-epoxycyclopentyl)methyl group, (3,4-epoxycyclohexyl)methyl group, 2-(3,4-epoxycyclopentyl)ethyl group, 2-(3,4-epoxycyclohexyl)ethyl group, 2-(3,4-epoxycyclopentyl)propyl group, 2-(3,4-epoxycyclohexyl)propyl group, 3-(3,4-epoxycylopentyl)propyl group and 3-(3,4-epoxycyclohexyl)propyl group, all of which have 5 to 20 carbon atoms.

Out of these monovalent organic groups having at least one epoxy group, γ-glycidoxypropyl group, 2-(3,4-epoxycyclohexyl)ethyl group and other monovalent organic groups having an epoxycyclohexyl group are preferred, and 2-(3,4-epoxycyclohexyl)ethyl group is particularly preferred.

In the formula (1), $Y^1$ is a chlorine atom, bromine atom, iodine atom, or linear, branched or cyclic alkoxyl group having 1 to 20 carbon atoms. These groups form a silanol group through a hydrolysis/condensation reaction in the presence of an organic base and water, and a condensation reaction occurs between the silanol groups or between the silanol group and a silicon atom having a chlorine atom, bromine atom, iodine atom or the alkoxyl group to form a siloxane bond.

Examples of the linear, branched or cyclic alkoxyl group having 1 to 20 carbon atoms represented by $Y^1$ in the formula (1) include methoxy group, ethoxy group, n-propoxy group, i-propoxy group, n-butoxy group, i-butoxy group, sec-butoxy group, t-butoxy group, n-pentyloxy group, n-hexyloxy group, cyclopentyloxy group and cyclohexyloxy group.

$Y^1$ in the formula (1) is preferably a chlorine atom, methoxy group or ethoxy group.

Examples of the linear, branched or cyclic alkyl group having 1 to 20 carbon atoms represented by $R^1$ in the formula (1) include methyl group, ethyl group, n-propyl group, i-propyl group, n-butyl group, i-butyl group, sec-butyl group, t-butyl group, n-pentyl group, n-hexyl group, cyclopentyl group and cyclohexyl group.

Examples of the linear, branched or cyclic substituted alkyl group having 1 to 20 carbon atoms represented by $R^1$ include fluoroalkyl groups such as fluoromethyl group, trifluoromethyl group, 2-fluoroethyl group, (trifluoromethyl)methyl group, pentafluoroethyl group, 3-fluoro-n-propyl group, 2-(trifluoromethyl)ethyl group, (pentafluoroethyl)methyl group, heptafluoro-n-propyl group, 4-fluoro-n-butyl group, 3-(trifluoromethyl)-n-propyl group, 2-(pentafluoroethyl)ethyl group, (heptafluoro-n-propyl)methyl group, nonafluoro-n-butyl group, 5-fluoro-n-pentyl group, 4-(trifluoromethyl)-n-butyl group, 3-(pentafluoroethyl)-n-propyl group, 2-(heptafluoro-n-propyl)ethyl group, (nonafluoro-n-butyl)methyl group, perfluoro-n-pentyl group, 6-fluoro-n-hexyl group, 5-(trifluoromethyl)-n-pentyl group, 4-(pentafluoroethyl)-n-butyl group, 3-(heptafluoro-n-propyl)-n-propyl group, 2-(nonafluoro-n-butyl)ethyl group, (perfluoro-n-pentyl)methyl group, perfluoro-n-hexyl group, 7-(trifluoromethyl)-n-heptyl group, 6-(pentafluoroethyl)-n-hexyl group, 5-(heptafluoro-n-propyl)-n-pentyl group, 4-(nonafluoro-n-butyl)-n-butyl group, 3-(perfluoro-n-pentyl)-n-propyl group, 2-(perfluoro-n-hexyl)ethyl group, (perfluoro-n-heptyl)methyl group, perfluoro-n-octyl group, 9-(trifluoromethyl)-n-nonyl group, 8-(pentafluoroethyl)-n-octyl group, 7-(heptafluoro-n-propyl)-n-heptyl group, 6-(nonafluoro-n-butyl)-n-hexyl group, 5-(perfluoro-n-pentyl)-n-pentyl group, 4-(perfluoro-n-hexyl)-n-butyl group, 3-(perfluoro-n-heptyl)-n-propyl group, 2-(perfluoro-n-octyl)ethyl group, (perfluoro-n-nonyl)methyl group, perfluoro-n-decyl group, 4-fluorocyclopentyl group and 4-fluorocyclohexyl group; and chloromethyl group, 2-chloroethyl group, 3-chloro-n-propyl group, 4-chloro-n-butyl group, 3-chlorocyclopentyl group, 4-chlorocyclohexyl group, hydroxymethyl group, 2-hydroxyethyl group, 3-hydroxycyclopentyl group, 4-hydroxycyclohexyl group, 3-(meth)acryloxypropyl group and 3-mercaptopropyl group.

Examples of the linear, branched or cyclic alkenyl group having 2 to 20 carbon atoms represented by $R^1$ include vinyl group, 1-methylvinyl group, 1-propenyl group, allyl group (2-propenyl group), 2-methyl-2-propenyl group, 1-butenyl group, 2-butenyl group, 3-butenyl group, 3-cyclopentenyl group and 3-cyclohexenyl group.

Examples of the aryl group having 6 to 20 carbon atoms represented by $R^1$ include phenyl group, o-tolyl group, m-tolyl group, p-tolyl group, 2,3-xylyl group, 2,4-xylyl group, 2,5-xylyl group, 2,6-xylyl group, 3,4-xylyl group, 3,5-xylyl group and 1-naphthyl group.

Examples of the aralkyl group having 7 to 20 carbon atoms represented by $R^1$ include benzyl group and phenethyl group.

$R^1$ in the formula (1) is preferably a methyl group or ethyl group.

Examples of the silane compound (1) include compounds of the formula (1) in which n is 0, such as γ-glycidoxypropyltrimethoxysilane, γ-glycidoxypropyltriethoxysilane, 2-(3,4-epoxycyclohexyl)ethyltrimethoxysilane and 2-(3,4-epoxyccylohexyl)ethyltriethoxysilane; compounds of the formula (1) in which n is 1, such as (γ-glycidoxypropyl)(methyl)dimethoxysilane, (γ-glycidoxypropyl)(ethyl)dimethoxysilane, (γ-glycidoxypropyl)(methyl)diethoxysilane, (γ-glycidoxypropyl)(ethyl)diethoxysilane, [2-(3,4-epoxycyclohexyl)ethyl](methyl)dimethoxysilane, [2-(3,4-epoxycyclohexyl)ethyl](ethyl)dimethoxysilane, [2-(3,4-epoxycyclohexyl)ethyl](methyl)diethoxysilane and [2-(3,4-epoxycyclohexyl)ethyl](ethyl)diethoxysilane; and compounds of the formula (1) in which n is 2, such as (y-glycidoxypropyl)(methoxy)dimethylsilane, (y-glycidoxypropyl)(methoxy)diethylsilane, (y-glycidoxypropyl)(ethoxy)dimethylsilane, (γ-glycidoxypropyl)(ethoxy)diethylsilane, [2-(3,4-epoxycyclohexyl)ethyl] (methoxy)dimethylsilane, [2-(3,4-epoxycyclohexyl)ethyl] (methoxy)diethylsilane, [2-(3,4-epoxycyclohexyl)ethyl](ethoxy)dimethylsilane and [2-(3,4-epoxycyclohexyl)ethyl](ethoxy)diethylsilane.

Commercially available products of the partial condensate of the silane compound (1) include ES1001N, ES1002T and ES1023 (of Shin-Etsu Silicones KK) and Methyl Silicate MSEP2 (of Mitsubishi Chemical Corporation).

In the present invention, the above silane compounds (1) and partial condensates thereof may be used alone or in combination of two or more.

In the formula (2), $Y^2$ is a chlorine atom, bromine atom, iodine atom, or linear, branched or cyclic alkoxyl group having 1 to 20 carbon atoms. These groups form a silanol group through a hydrolysis/condensation reaction in the presence of an organic base and water, and a condensation reaction occurs between the silanol groups or between the silanol group and a silicon atom having a chlorine atom, bromine atom, iodine atom or the alkoxyl group to form a siloxane bond.

Examples of the linear, branched or cyclic alkoxyl group having 1 to 20 carbon atoms represented by $Y^2$ in the formula (2) are the same as those enumerated for the corresponding group represented by $Y^1$ in the above formula (1).

$Y^2$ in the formula (2) is preferably a chlorine atom, methoxy group, ethoxy group, n-propoxy group, i-propoxy group, n-butoxy group, sec-butoxy group or t-butoxy group.

Examples of the linear, branched or cyclic alkyl group having 1 to 20 carbon atoms, linear, branched or cyclic substituted alkyl group having 1 to 20 carbon atoms, linear, branched or cyclic alkenyl group having 2 to 20 carbon atoms, aryl group having 6 to 20 carbon atoms, and aralkyl group having 7 to 20 carbon atoms all of which are represented by $R^2$ in the formula (2) are the same as those enumerated for the corresponding groups represented by $R^1$ in the above formula (1).

$R^2$ in the formula (2) is preferably a fluorine atom, methyl group, ethyl group, 2-(trifluoromethyl)ethyl group, 2-(perfluoro-n-hexyl)ethyl group, 2-(perfluoro-n-octyl)ethyl group, hydroxymethyl group, 2-hydroxyethyl group, 3-(meth)acryloxypropyl group, 3-mercaptopropyl group, vinyl group, allyl group or phenyl group.

Examples of the silane compound (2) include compounds of the formula (2) in which m is 0, such as tetrachlorosilane, tetramethoxysilane, tetraethoxysilane, tetra-n-propoxysilane, tetra-i-propoxysilane, tetra-n-butoxysilane and tetra-sec-butoxysilane; compounds of the formula (2) in which m is 1, such as trichlorosilane, trimethoxysilane, triethoxysilane, tri-n-propoxysilane, tri-i-propoxysilane, tri-n-butoxysilane, tri-sec-butoxysilane, fluorotrichlorosilane, fluorotrimethoxysilane, fluorotriethoxysilane, fluorotri-n-propoxysilane, fluorotri-i-propoxysilane, fluorotri-n-butoxysilane, fluorotri-sec-butoxysilane, methyl trichlorosilane, methyl trimethoxysilane, methyl triethoxysilane, methyl tri-n-propoxysilane, methyl tri-i-propoxysilane, methyl tri-n-butoxysilane, methyl tri-sec-butoxysilane, 2-(trifluoromethyl)ethyltrichlorosilane, 2-(trifluoromethyl)ethyltrimethoxysilane, 2-(trifluoromethyl)ethyltriethoxysilane, 2-(trifluoromethyl)ethyltri-n-propoxysilane, 2-(trifluoromethyl)ethyltri-i-propoxysilane, 2-(trifluoromethyl)ethyltri-n-butoxysilane, 2-(trifluoromethyl)ethyltri-sec-butoxysilane, 2-(perfluoro-n-hexyl)ethyltrichlorosilane, 2-(perfluoro-n-hexyl)ethyltrimethoxysilane, 2-(perfluoro-n-hexyl)ethyltriethoxysilane, 2-(perfluoro-n-hexyl)ethyltri-n-propoxysilane, 2-(perfluoro-n-hexyl)ethyltri-i-propoxysilane, 2-(perfluoro-n-hexyl)ethyltri-n-butoxysilane, 2-(perfluoro-n-hexyl)ethyltri-sec-butoxysilane, 2-(perfluoro-n-octyl)ethyltrichlorosilane, 2-(perfluoro-n-octyl)ethyltrimethoxysilane, 2-(perfluoro-n-octyl)ethyltriethoxysilane, 2-(perfluoro-n-octyl)ethyltri-n-propoxysilane, 2-(perfluoro-n-octyl)ethyltri-i-propoxysilane, 2-(perfluoro-n-octyl)ethyltri-n-butoxysilane, 2-(perfluoro-n-octyl)ethyltri-sec-butoxysilane, hydroxymethyltrichlorosilane, hydroxymethyltrimethoxysilane, hydroxyethyltrimethoxysilane, hydroxymethyltri-n-propoxysilane, hydroxymethyltri-i-propoxysilane, hydroxymethyltri-n-butoxysilane, hydroxymethyltri-sec-butoxysilane, 3-(meth)acryloxypropyltrichlorosilane, 3-(meth)acryloxypropyltrimethoxysilane, 3-(meth)acryloxypropyltriethoxysilane, 3-(meth)acryloxypropyltri-n-propoxysilane, 3-(meth)acryloxypropyltri-i-propoxysilane, 3-(meth)acryloxypropyltri-n-butoxysilane, 3-(meth)acryloxypropyltri-sec-butoxysilane, 3-mercaptopropyltrichlorosilane, 3-mercaptopropyltrimethoxysilane, 3-mercaptopropyltriethoxysilane, 3-mercaptopropyltri-n-propoxysilane, 3-mercaptopropyltri-i-propoxysilane, 3-mercaptopropyltri-n-butoxysilane, 3-mercaptopropyltri-sec-butoxysilane, vinyltrichlorosilane, vinyltrimethoxysilane, vinyltriethoxysilane, vinyltri-n-propoxysilane, vinyltri-i-propoxysilane, vinyltri-n-butoxysilane, vinyltri-sec-butoxysilane, allyltrichlorosilane, allyltrimethoxysilane, allyltriethoxysilane, allyltri-n-propoxysilane, allyltri-i-propoxysilane, allyltri-n-butoxysilane, allyltri-sec-butoxysilane, phenyltrichlorosilane, phenyltrimethoxysilane, phenyltriethoxysilane, phenyltri-n-propoxysilane, phenyltri-i-propoxysilane, phenyltri-n-butoxysilane and phenyltri-sec-butoxysilane; compounds of the formula (2) in which m is 2, such as methyldichlorosilane, methyldimethoxysilane, methyldiethoxysilane, methyldi-n-propoxysilane, methyldi-i-propoxysilane, methyldi-n-butoxysilane, methyldi-sec-butoxysilane, dimethyldichlorosilane, dimethyldimethoxysilane, dimethyldiethoxysilane, dimethyldi-n-propoxysilane, dimethyldi-i-propoxysilane, dimethyldi-n-butoxysilane, dimethyldi-sec-butoxysilane, (methyl)[2-(perfluoroo-n-ctyl)ethyl] dichlorosilane, (methyl)[2-(perfluoroo-n-ctyl)ethyl]dimethoxysilane, (methyl)[2-(perfluoroo-n-ctyl)ethyl]diethoxysilane, (methyl)[2-(perfluoroo-n-ctyl)ethyl]di-n-propoxysilane, (methyl)[2-(perfluoroo-n-ctyl)ethyl]di-i-propoxysilane, (methyl) [2-(perfluoroo-n-ctyl)ethyl]di-n-butoxysilane, (methyl)[2-(perfluoroo-n-ctyl)ethyl]di-sec-butoxysilane, (methyl)(y-glycidoxypropyl)dichlorosilane, (methyl)($\gamma$-glycidoxypropyl)dimethoxysilane, (methyl)(y-glycidoxypropyl)diethoxysilane, (methyl)(y-glycidoxypropyl)di-n-propoxysilane, (methyl)($\gamma$-glycidoxypropyl)di-i-propoxysilane, (methyl)(y-glycidoxypropyl) di-n-butoxysilane, (methyl)(y-glycidoxypropyl)di-sec-butoxysilane, (methyl)(3-mercaptopropyl)dichlorosilane, (methyl) (3-mercaptopropyl)dimethoxysilane, (methyl)(3-mercaptopropyl)diethoxysilane, (methyl)(3-mercaptopropyl)di-n-propoxysilane, (methyl)(3-mercaptopropyl)di-i-propoxysilane, (methyl)(3-mercaptopropyl)di-n-butoxysilane, (methyl)(3-mercaptopropyl)di-sec-butoxysilane, (methyl)(vinyl)dichlorosilane, (methyl)(vinyl)dimethoxysilane, (methyl)(vinyl)diethoxysilane, (methyl)(vinyl)di-n-propoxysilane, (methyl)(vinyl)di-i-propoxysilane, (methyl)(vinyl)di-n-butoxysilane, (methyl)(vinyl)di-sec-butoxysilane, divinyldichlorosilane, divinyldimethoxysilane, divinyldiethoxoysilane, divinyldi-n-propoxysilane, divinyldi-i-propoxysilane, divinyldi-n-butoxysilane, divinyldi-sec-butoxysilane, diphenyldichlorosilane, diphenyldimethoxysilane, diphenyldiethoxysilane, diphenyldi-n-propoxysilane, diphenyldi-i-propoxysilane, diphenyldi-n-butoxysilane and diphenyldi-sec-butoxysilane; and compounds of the formula (2) in which m is 3, such as chlorodimethylsilane, methoxydimethylsilane, ethoxydimethylsilane, chlorotrimethylsilane, bromotrimethylsilane, iodotrimethylsilane, methoxytrimethylsilane, ethoxytrimethylsilane, n-propoxytrimethylsilane, i-propoxytrimethylsilane, n-butoxytrimethylsilane, sec-butoxytrimethylsilane, t-butoxytrimethylsilane, (chloro)(vinyl)dimethylsilane, (methoxy)(vinyl)dimethylsilane, (ethoxy)(vinyl)dimethylsilane, (chloro)(methyl)diphenylsilane, (methoxy)(methyl)diphenylsilane and (ethoxy) (methyl) diphenylsilane.

Out of these silane compounds (2), tetramethoxysilane, tetraethoxysilane, methyltrimethoxysilane, methyltriethoxysilane, 3-(meth)acryloxypropyltrimethoxysilane, 3-(meth)acryloxypropyltriethoxysilane, vinyltrimethoxysilane, vinyltriethoxysilane, allyltrimethoxysilane, allyltriethoxysilane, phenyltrimethoxysilane, phenyltriethoxysilane, dimethyldimethoxysilane and dimethyldiethoxysilane are preferred.

Commercially available products of the partial condensate of the silane compound (2) include KC-89, KC-89S, X-21-3153, X-21-5841, X-21-5842, X-21-5843, X-21-5844, X-21-5845, X-21-5846, X-21-5847, X-21-5848, X-22-160AS, X-22-170B, X-22-170BX, X-22-170D, X-22-170DX, X-22-176B, X-22-176D, X-22-176DX, X-22-176F, X-40-2308, X-40-2651, X-40-2655A, X-40-2671, X-40-2672, X-40-9220, X-40-9225, X-40-9227, X-40-9246, X-40-9247, X-40-9250, X-40-9323, X-41-1053, X-41-1056, X-41-1805, X-41-1810, KF6001, KF6002, KF6003, KR212, KR-213, KR-217, KR220L, KR242A, KR271, KR282, KR300, KR311, KR401N, KR500, KR510, KR5206, KR5230, KR5235, KR9218 and KR9706 (of Shin-Etsu Silicones KK); Glass Resin (of Showa Denko K.K.); SH804, SH805, SH806A, SH840, SR2400, SR2402, SR2405, SR2406, SR2410, SR2411, SR2416 and SR2420 (of Toray Dow Corning Silicone Co., Ltd.); FZ3711 and FZ3722 (of Nippon Unicar Co., Ltd.); DMS-S12, DMS-S15, DMS-S21, DMS-S27, DMS-S31, DMS-S32, DMS-S33, DMS-S35, DMS-S38, DMS-S42, DMS-S45, DMS-S51, DMS-227, PDS-0332, PDS-1615, PDS-9931 and XMS-5025 (of Chisso Corporation); Methyl Silicate MS51 and Methyl Silicate MS56 (of Mitsubishi Chemical Corporation) ; Ethyl Silicate 28, Ethyl Silicate 40 and Ethyl Silicate 48 (of Colcoat Co. , Ltd.); and GR100, GR650, GR908 and GR950 (of Showa Denko K.K.).

In the present invention, the above silane compounds (2) and partial condensates thereof may be used alone or in combination of two or more.

The polyorganosiloxane ($\alpha$) is preferably prepared by hydrolyzing/condensing the silane compound (1), etc. and the silane compound (2), etc. under heating in the presence of an organic solvent, an organic base and water.

The above organic solvent is, for example, a hydrocarbon, ketone, ester, ether or alcohol.

Examples of the above hydrocarbon include toluene and xylene; examples of the above ketone include methyl ethyl ketone, methyl isobutyl ketone, methyl n-amylketone, diethyl ketone and cyclohexanone; examples of the above ester include ethyl acetate, n-butyl acetate, i-amyl acetate, propylene glycol monomethyl ether acetate, 3-methoxybutyl acetate and ethyl lactate; examples of the above ether include ethylene glycol dimethyl ether, ethylene glycol diethyl ether, tetrahydrofuran and dioxane; and examples of the above alcohol include 1-hexanol, 4-methyl-2-pentanol, ethylene glycol monomethyl ether, ethylene glycol monoethyl ether, ethylene glycol mono-n-propyl ether, ethylene glycol mono-n-butyl ether, propylene glycol monomethyl ether, propylene glycol monoethyl ether and propylene glycol mono-n-propyl ether. Out of these, water-insoluble organic solvents are preferred.

These organic solvents may be used alone or in combination of two or more.

The amount of the organic solvent is preferably 50 to 10,000 parts by weight, more preferably 100 to 5,000 parts by weight based on 100 parts by weight of the total of all silane compounds.

Examples of the above organic base include primary and secondary organic amines such as ethylamine and diethylamine; tertiary organic amines such as triethylamine, tri-n-propylamine, tri-n-butylamine, pyridine and 4-dimethylaminopyridine; and quaternary organic amines such as tetramethylammonium hydroxide.

Out of these organic bases, tertiary organic amines such as triethylamine, tri-n-propylamine, tri-n-butylamine, pyridine and 4-dimethylaminopyridine; and quaternary organic amines such as tetramethylammonium hydroxide are preferred.

When an organic base is used as a catalyst for the manufacture of the polyorganosiloxane ($\alpha$), a polyorganosiloxane ($\alpha$) of interest can be obtained at a high hydrolysis/condensation rate without causing a side reaction such as the ring opening of an epoxy group, thereby making it possible to obtain a composition having high production stability and excellent curability.

The amount of the organic amine which differs according to the type of the organic amine and reaction conditions such as temperature is not particularly limited but preferably 0.01 to 3 times, more preferably 0.05 to 1 time the molar amount of all the silane compounds. When an organic base other than organic amines is used, its amount is almost the same as that of the organic amine.

The amount of water for the manufacture of the polyorganosiloxane ($\alpha$) is preferably 0.5 to 100 times, more preferably 1 to 30 times the molar amount of all the silane compounds.

The hydrolysis/condensation reaction for the manufacture of the polyorganosiloxane ($\alpha$) can be carried out by dissolving the silane compound (1), etc. and the silane compound (2), etc. in an organic solvent, mixing the obtained solution with an organic base and water, and heating the resulting mixture in an oil bath.

For the hydrolysis/condensation reaction, the heating temperature is preferably 130˚C or lower, more preferably 40 to 120˚C, and the heating time is preferably 0.5 to 12 hours, more preferably 1 to 8 hours. During heating, the mixed solution may be stirred or left under reflux.

After the end of the reaction, the organic solvent layer is separated from the reaction solution and rinsed with water usually. For this rinsing, water containing a small amount of salt, for example, an aqueous solution containing 0.2 wt% of ammonium nitrate is used to facilitate the rinsing operation. Rinsing is carried out until water after rinsing becomes neutral, and then the organic solvent layer is optionally dried with a desiccant such as anhydrous calcium sulfate or molecular sieves and condensed to obtain the polyorganosiloxane ($\alpha$) of interest.

Since the obtained polyorganosiloxane ($\alpha$) has low contents of the residual hydrolytic group (such as alkoxyl group) and silanol group, it can be kept ungelled at room temperature for 1 month or longer without being diluted with a solvent. Optionally, after the end of the reaction, the content of the silanol group can be further reduced by trimethylsilylating the residual silanol group with hexamethyldisilazane, trimethylchlorosilane or ethyl orthoformate.

The hydrolysis/condensation reaction in the presence of an organic base and water has advantages that a side reaction such as the ring opening reaction of an epoxy group in the silane compound (1), etc. or a polymerization reaction does not occur and that the contents of metal impurities such as sodium, potassium, platinum and ruthenium in the polyorganosiloxane ($\alpha$) are low as compared with a case where a metal-containing catalyst is used. Preferably, the platinum, rhodium, ruthenium, cobalt, palladium and nickel contents of the polyorganosiloxane ($\alpha$) are each 10 ppm or less. When the contents of these metals are more than 10 ppm, the obtained polyorganosiloxane ($\alpha$) may be colored by heat.

The weight average molecular weight in terms of polystyrene (to be referred to as "Mw" hereinafter) of the polyorganosiloxane ($\alpha$) is 500 to 1,000,000, preferably 1,000 to 100,000.

Preferably, the polyorganosiloxane ($\alpha$) satisfies at least one of the following condition related to epoxy equivalent and the following condition related to the amount of a structural unit derived from the silane compound (1).

That is, the epoxy equivalent is preferably 1,600 g/mol or less, more preferably 160 to 900 g/mol, much more preferably 180 to 500 g/mol. When the epoxy equivalent is more than 1,600 g/mol, the obtained polyorganosiloxane may experience a reduction in heat resistance or may be colored.

Preferably, the polyorganosiloxane ($\alpha$) has an epoxy equivalent of 1,600 g/mol or less and contains each of

platinum, ruthenium, cobalt, palladium and nickel in amounts of 10 ppm at maximum.

The amount of the structural unit derived from the silane compound (1) is preferably 5 mol% or more, more preferably 10 to 90 mol%, much more preferably 20 to 80 mol% of the total of all the structural units. When the amount of the structural unit is smaller than 5 mol% of the total of all the structural units, the obtained polyorganosiloxane may experience a reduction in heat resistance or may be colored.

Further, it is desired that the epoxy equivalent of the polyorganosiloxane ($\alpha$) should satisfy the above condition and that the ratio of the number of silicon atoms bonded to 3 or more oxygen atoms to the total number of silicon atoms of the polyorganosiloxane ($\alpha$) should be 10 % or more, preferably 20 % or more. When the ratio of the number of silicon atoms bonded to 3 or more oxygen atoms to the total number of silicon atoms is less than 10 %, the hardness and adhesion to a substrate of a cured product obtained from the optical semiconductor sealing composition which will be described hereinafter may become unsatisfactory.

The polyorganosiloxane ($\alpha$) can be used extremely advantageously as the main component of the optical semiconductor sealing composition which will be described hereinafter and is useful for molded articles, films, laminated materials and coatings as it is or as a mixture with an ordinary polyorganosiloxane.

Optical semiconductor sealing composition and preparation process thereof

The optical semiconductor sealing composition of the present invention is [I] an optical semiconductor sealing composition comprising:

(A) a polyorganosiloxane ($\alpha$) (to be referred to as "(A) polyorganosiloxane" hereinafter) which satisfies at least one of the following conditions:

(i) the epoxy equivalent is 1,600 g/mol or less, and
(ii) the content of a structural unit derived from a silane compound represented by the formula (1) is 5 mol% or more of the total of all the structural units; and

(B1) a carboxylic anhydride,

[II] an optical semiconductor sealing composition comprising (A) a polyorganosiloxane, (B1) a carboxylic anhydride-based curing agent and (C) a curing accelerator, or
[III] an optical semiconductor sealing composition comprising (A) a polyorganosiloxane and (B2) a thermal acid generator.

In the optical semiconductor sealing compositions [I], [II] and [III], the polyorganosiloxanes (A) may be used alone or in combination of two or more.

- (B1) carboxylic anhydride -

The carboxylic anhydride (B1) in the optical semiconductor sealing composition [I] and the optical semiconductor sealing composition [II] is a component (curing agent) for causing a curing reaction with the polyorganosiloxane (A).

The carboxylic anhydride (B1) is not particularly limited but preferably an alicyclic carboxylic anhydride.

Examples of the above alicyclic carboxylic anhydride include compounds represented by the following formula (3) to (12), 4-methyltetrahydrophthalic anhydride, methyl nadic anhydride, dodecenylsuccic anhydride, Diels-Alder reaction products of an alicyclic compound having a conjugated double bond such as $\alpha$-terpinen or allo-ocimene and maleic anhydride, and hydrogenated products thereof. As the Diels-Alder reaction products and hydrogenated products thereof may be used any structural isomers and any geometric isomers.

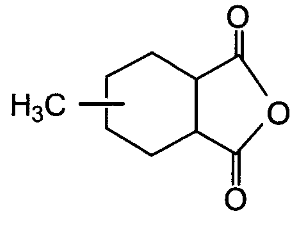 (3) ,

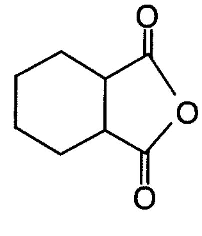 (4) ,

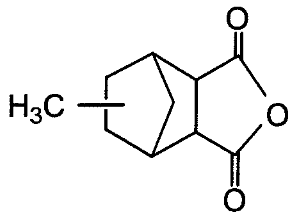

(5) 、

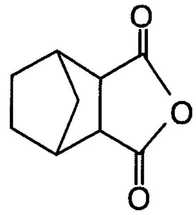

(6) 、

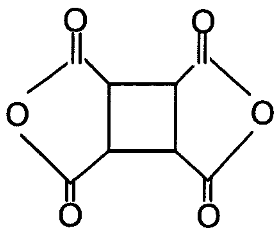

(7) 、

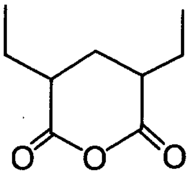

(8) 、

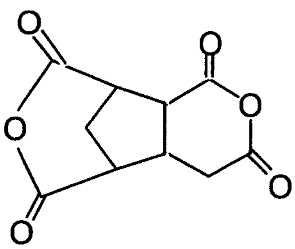

(9) 、

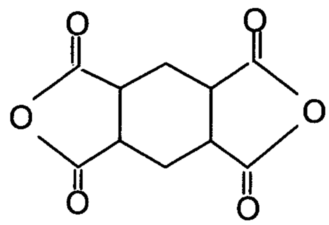

(10) 、

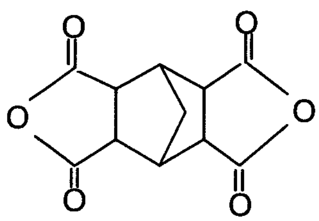

(11) 、

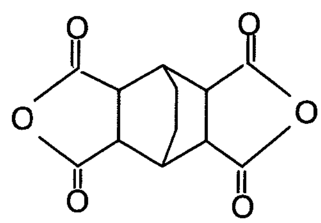

(12) 、

The above alicyclic carboxylic anhydride may be suitably chemically modified before use as far as a curing reaction is not impeded substantially.

Out of these alicyclic carboxylic anhydrides, the compounds represented by the formulas (3), (5), (7), (8) and (9) are preferred from the viewpoints of the fluidity and transparency of the obtained composition, and the compounds represented by the formulas (3), (5) and (7) are particularly preferred.

In the present invention, the above alicyclic carboxylic anhydrides may be used alone or in combination of two or more.

In the optical semiconductor sealing composition [I] and the optical semiconductor sealing composition [II], at least one aliphatic carboxylic anhydride or aromatic carboxylic anhydride may be used as the carboxylic anhydride (B1). They are preferably used in conjunction with an alicyclic carboxylic anhydride.

The aliphatic carboxylic anhydride and the aromatic carboxylic anhydride may also be suitably chemically modified before use as far as the curing reaction is not impeded substantially.

The total amount of the aliphatic carboxylic anhydride and the aromatic carboxylic anhydride is preferably 50 wt% or less, more preferably 30 wt% or less of the total of the alicyclic carboxylic anhydride and them.

As for the amount of the carboxylic anhydride (B1) in the optical semiconductor sealing composition [I] and the optical semiconductor sealing composition [II], the equivalent ratio of the carboxylic anhydride group to 1 mol of the epoxy group in the polyorganosiloxane (A) is preferably 0.3 to 1.5, more preferably 0.5 to 1.3. When the equivalent ratio

is less than 0.3 or more than 1.5, the obtained cured product may experience a reduction in glass transition point (Tg) or may be colored.

Further, in the optical semiconductor sealing composition [I] and the optical semiconductor sealing composition [II], besides the above carboxylic anhydride (B1), at least one known component (to be referred to as "other curing agent" hereinafter) such as a phenol, dicyandiamide or organic hydrazide exemplified by hydrazide adipate and hydrazide phthalate may be used as a curing agent for the epoxy compound or epoxy resin as far as the effect of the present invention is not adversely affected.

The amount of the other curing agent is preferably 50 wt% or less, more preferably 30 wt% or less based on the carboxylic anhydride (B1).

- (C) curing accelerator -

The curing accelerator (C) in the optical semiconductor sealing composition [II] is a component for accelerating a curing reaction between the polyorganosiloxane (A) and the carboxylic anhydride (B1).

The curing accelerator (C) is not particularly limited, as exemplified by tertiary amines such as benzyldimethylamine, 2,4,6-tris(dimethylaminomethyl)phenol, cyclohexyldimethylamine and triethanolamine; imidazoles such as 2-methylimidazole, 2-n-heptylimidazole, 2-n-undecylimidazole, 2-phenylimidazole, 2-phenyl-4-methylimidazole, 1-benzyl-2-methylimidazole, 1-benzyl-2-phenylimidazole, 1,2-dimethylimidazole, 2-ethyl-4-methylimidazole, 1-(2-cyanoethyl)-2-methylimidazole, 1-(2-cyanoethyl)-2-n-undecylimidazole, 1-(2-cyanoethyl)-2-phenylimidazole, 1-(2-cyanoethyl)-2-ethyl-4-methylimiazole, 2-phenyl-4-methyl-5-hydroxymethylimidazole, 2-phenyl-4,5-di(hydroxymethyl)imidazole, 1-(2-cyanoethyl)-2-phenyl-4,5-di[(2'-cyanoethoxy)methyl] imidazole, 1-(2-cyanoethyl)-2-n-undecylimidazolium trimellitate, 1-(2-cyanoethyl)-2-phenylimidazolium trimellitate, 1-(2-cyanoethyl)-2-ethyl-4-methylimidazolium trimellitate, 2,4-diamino-6-[2'-methylimidazolyl-(1')]ethyl-s-triazine, 2,4-diamino-6-(2'-n-undecylimidazolyl)ethyl-s-triazine, 2,4-diamino-6-[2'-ethyl-4'-methylimidazolyl-(1')]ethyl-s -triazine, isocyanuric acid adduct of 2-methylimidazole, isocyanuric acid adduct of 2-phenylimidazole and isocyanuric acid adduct of 2,4-diamino-6-[2'-methylimidazolyl-(1')]ethyl-s-triazine; organic phosphorus compounds such as diphenylphosphine, triphenylphosphine and triphenyl phosphite; quaternary phosphonium salts such as benzyltriphenylphosphonium chloride, tetra-n-butylphosphonium bromide, methyltriphenylphosphonium bromide, ethyltriphenylphosphonium bromide, n-butyltriphenylphosphonium bromide, tetraphenylphosphonium bromide, ethyltriphenylphosphonium iodide, ethyltriphenylphosphonium acetate, tetra-n-butylphosphonium o,o-diethylphosphorodithionate, tetra-n-butylphosphonium benzotriazolate, tetra-n-butylphosphonium tetrafluoroborate, tetra-n-butylphosphonium tetraphenylborate and tetraphenylphosphonium tetraphenylborate; diazabicycloalkenes such as 1,8-diazabicyclo[5.4.0]undecene-7 and organic acid salts thereof; organic metal compounds such as zinc octylate, tin octylate and aluminum acetylacetone complex; quaternary ammonium salts such as tetraethylammonium bromide and tetra-n-butylammonium bromide; boron compounds such as boron trifluoride and triphenyl borate; high melting point dispersible latent curing accelerators such as metal halogen compounds including zinc chloride and stannic chloride and amine addition type accelerators including dicyan diamide and adduct of amine and epoxy resin; latent curing accelerators including microcapsule type latent curing accelerators prepared by coating the surface of a curing accelerator such as the above imidazole, organic phosphorus compound or quaternary phosphonium salt with a polymer; amine salt type latent curing accelerators; and high-temperature dissociation type heat cationic polymerization type latent curing accelerators such as Lewis acid salts and Brϕnsted acid salts.

Out of these curing accelerators (C), imidazoles, quaternary phosphonium salts, diazabicycloalkenes, organic metal compounds and quaternary ammonium salts are preferred because a cured product which is achromatic and transparent and is hardly colored even when it is heated for a long time is obtained.

The above curing accelerators (C) may be used alone or in combination of two or more.

In the optical semiconductor sealing composition [II], the amount of the curing accelerator (C) is preferably 0.01 to 6 parts by weight, more preferably 0.1 to 4 parts by weight based on 100 parts by weight of the polyorganosiloxane (A). When the amount of the curing accelerator (C) is smaller than 0.01 part by weight, the effect of accelerating the curing reaction may lower and when the amount is larger than 6 parts by weight, the obtained cured product may be colored.

- (B2) thermal acid generator -

The thermal acid generator (B2) in the optical semiconductor sealing composition [III] is a component which forms an acid by heating to cause the curing reaction of the polyorganosiloxane (A).

The thermal acid generator (B2) is not particularly limited, as exemplified by compounds represented by the following formulas (13) to (18) (to be referred to as "compound (13) to compound (18)" hereinafter).

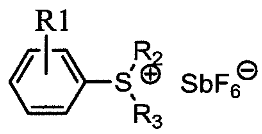

・・・(13)

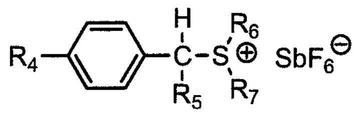

・・・(14)

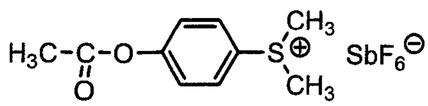

・・・(15)

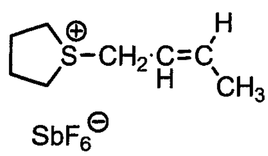

・・・(16)

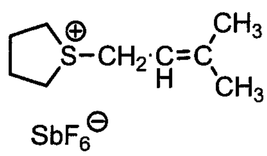

・・・(17)

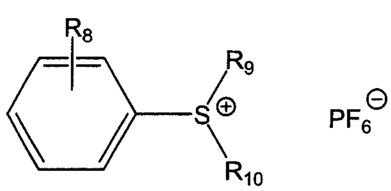

・・・(18)

In the above formulas, $R_1$ to $R_{10}$ are each an alkyl group. Out of these, the compound (16) and the compound (17) are preferred. The amount of the thermal acid generator is preferably 0.001 to 20 parts by weight, more preferably 0.01 to 10 parts by weight, much more preferably 0.05 to 5 parts by weight based on 100 parts by weight of the polyorganosiloxane (A).

- other additives -

Inorganic oxide particles may be optionally added to the optical semiconductor sealing compositions [I], [II] and [III] of the present invention in order to improve UV resistance and adjust viscosity.

The inorganic oxide particles which are not particularly limited may be particles of an oxide containing at least one element selected from the group consisting of Si, Al, Zr, Ti, Zn, Ge, In, Sn, Sb and Ce. Specific examples of the

inorganic oxide particles include particles of silica, alumina, zirconia, titanium oxide, zinc oxide, germanium oxide, indium oxide, tin oxide, indium-tin oxide (ITO), antimony oxide, antimony-tin oxide (ATO) and cerium oxide.

Out of these inorganic oxide particles, fine particles of silica, alumina, zirconia and antimony oxide are preferred.

The above inorganic oxide particles may be subjected to a suitable surface treatment by alkylation, polysiloxylation, (meth)acryloxyalkylation, glycoxyalkylation or aminoalkylation before use.

The above inorganic oxide particles may be used alone or in combination of two or more.

Optionally, at least one dispersant such as an anionic surfactant, cationic surfactant, nonionic surfactant or polymer dispersant may be used in conjunction with the inorganic oxide particles.

The average primary particle diameter of the inorganic oxide particles is preferably 100 nm or less, more preferably 1 to 80 nm. When the average primary particle diameter of the inorganic oxide particles is larger than 100 nm, the transparency of the obtained cured product may be impaired.

The amount of the inorganic oxide particles is preferably 90 parts or less by weight, more preferably 80 parts or less by weight based on 100 parts by weight of the polyorganosiloxane (A). When the amount of the inorganic oxide particles is larger than 90 parts by weight, the composition becomes viscous and may be difficult to be processed.

The above inorganic oxide particles may be prepared as a dispersion containing a suitable solvent according to circumstances.

The above solvent is not particularly limited if it is unreactive with the components of the optical semiconductor sealing composition of the present invention and in the curing reaction and has suitable volatility. Examples of the solvent include alcohols such as methanol, ethanol, i-propanol, n-butanol, n-octanol, ethylene glycol monomethyl ether, ethylene glycol monoethyl ether, diethylene glycol mono-n-butyl ether, propylene glycol monomethyl ether and propylene glycol monoethyl ether; ketones such as acetone, methyl ethyl ketone, methyl isobutyl ketone and cyclohexanone; esters and lactones such as ethyl acetate, n-butyl acetate, ethyl lactate, propylene glycol monomethyl ether acetate, propylene glycol monoethyl ether acetate and $\gamma$-butyrolactone; aromatic hydrocarbons such as benzene, toluene and xylene; and amides and lactams such as dimethylformamide, dimethylacetamide and N-methylpyrrolidone.

These solvents may be used alone or in combination of two or more.

The solid content of the dispersion of the inorganic oxide particles is preferably 1 to 60 wt%, more preferably 5 to 50 wt%.

The inorganic oxide particles and dispersion thereof are available on the market, and these commercially available products may be used.

As for commercially available products (trade names) of the inorganic oxide particles and dispersion thereof, those of a silica particle dispersion include Methanol Silica Sol, IPA-ST, MEK-ST, NBA-ST, XBA-ST, DMAC-ST, ST-UP, ST-OUP, ST-C, ST-N, ST-O, ST-OL, ST-20, ST-40 and ST-50 (of Nissan Chemical Industries, Ltd.); and Organo Sol PL-2PGME (propylene glycol monomethyl ether dispersion of Fuso Chemical Co., Ltd.), those of silica particles include Aerogel 130, Aerogel 300, Aerogel 380, Aerogel TT600 and Aerogel OX50 (of Nippon Aerogel Co. , Ltd.); Sildex H31, Sildex H32, Sildex H51, Sildex H52, Sildex H121 and Sildex H122 (of Asahi Glass Co. , Ltd.) ; E220A and E220 (of Nippon Silica Co. , Ltd.) ; and SYLYSIA470 (of Fuji Sylysia Co., Ltd.) and SG flake (of Nippon Sheet Glass Co., Ltd.), those of an alumina particle dispersion include Alumina Sol-100, Alumina Sol-200 and Alumina Sol-520 (water dispersions of Nissan Chemical Industries, Ltd) ; AS-1501 (i-propanol dispersion of Sumitomo Osaka Cement Co., Ltd.); and AS-150T (toluene dispersion of Sumitomo Osaka Cement Co., Ltd.), those of a zirconia particle dispersion include HXU-110JC (toluene dispersion of Sumitomo Osaka Cement Co., Ltd.), those of a zinc antimonate particle dispersion include Celnax (water dispersion of Nissan Chemical Industries, Ltd.), and those of a cerium oxide particle dispersion include Niedrale (water dispersion of Taki Kagaku Co., Ltd.).

An antioxidant, optical stabilizer and ultraviolet light absorber may be optionally added to the optical semiconductor sealing compositions [I], [II] and [III] of the present invention in order to suppress the coloring of their cured products.

Commercially available products of the antioxidant include Sumilizer BHT, Sumilizer GM, Sumilizer GS, Sumilizer MDP-S, Sumilizer BBM-S, Sumilizer WX-R, Sumilizer GA-80, Sumilizer TPL-R, Sumilizer TPM, Sumilizer TPS and Sumilizer TP-D (of Sumitomo Chemical Industries, Ltd.); Irganox 1076, Irganox 565, Irganox 1520, Irganox 245, Irganox 1010, Irganox 1098, Irganox 1330, Irganox 1425, Irganox 3114 and Irganox MD-1024 (of Ciba Specialty Chemicals Holding Inc.); Cyanox 1790 (of Cytec Co., Ltd.); TNP (of Yokkaichi Gosei Co., Ltd.); Weston 618 (of Vorg Warner Co., Ltd.); Irgafos 168 (of Ciba Specialty Chemicals Holding Inc.); Adekastab PEP-36 and Adekastab HP-10 (of Asahi Denka Kogyo K.K.); and Sandstab P-EPQ and Ultranox 626.

Commercially available products of the above optical stabilizer include Viosorb 04 (of Kyodo Yakuhin Co., Ltd.); Tinuvin 622 and Tinuvin 765 (of Ciba Specialty Chemicals Holding Inc., Ltd.); Cyasorb UV-3346 (of Cytec Co., Ltd.); Adekastab LA-57 (of Asahi Denka Kogyo K.K.) and Chimassorb 119 and Chimassorb 944.

Commercially available products of the above ultraviolet light absorber include Viosorb 80, Viosorb 110, Viosorb 130, Viosorb 520, Viosorb 583 and Viosorb 590 (of Kyodo Yakuhin Co., Ltd.); Tinuvin P, Tinuvin 213, Tinuvin 234, Tinuvin 320, Tinuvin 326 and Tinuvin 328 (of Ciba Specialty Chemicals Holding Inc.); and Adekastab LA-31 (of Asahi Denka Kogyo K.K.).

Further, a carbonic acid gas generation inhibitor such as an alicyclic epoxy compound, aromatic epoxy compound, aliphatic polyol exemplified by ethylene glycol and propylene glycol, aliphatic or aromatic carboxylic acid, or phenol compound; flexibility providing agent such as polyalkylene glycol or polydimethylsiloxane derivative; impact resistance accelerator such as a rubber or organic polymer bead; plasticizer, lubricant, other silane coupling agent, retardant, antistatic agent, leveling agent, ion trapping agent, slidability accelerator, thioxotropy providing agent, surface tension reducing agent, antifoaming agent, anti-settling agent, antioxidant, release agent, fluorescent agent, colorant, conductive filler and other additives may be optionally added to the optical semiconductor sealing composition of the present invention as far as the effect of the present invention is not adversely affected.

Examples of the above alicyclic epoxy compound include compounds represented by the following formulas (19) to (25).

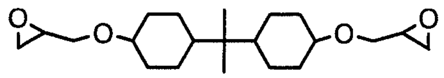

・・・(19)

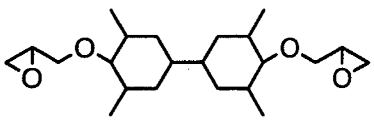

・・・(20)

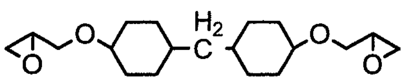

・・・(21)

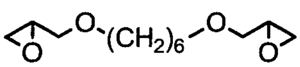

・・・(22)

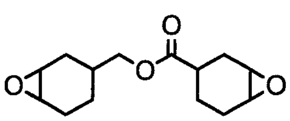

・・・(23)

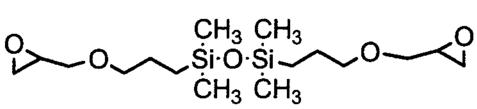

・・・(24)

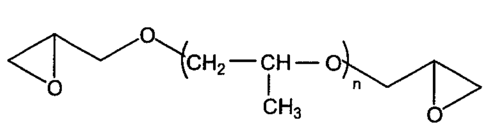

・・・(25)

Commercially available products of the compound (19) include HBE100 (of Shin Nippon Rika Co., Ltd.) and YX8000 (of Japan Epoxy Resin Co., Ltd.), those of the compound (20) include YL7040 (of Japan Epoxy Resin Co., Ltd.), those of the compound (20) include YL6753 (of Japan Epoxy Resin Co., Ltd.), those of the compound (22) include YED216D (of Japan Epoxy Resin Co., Ltd.), those of the compound (23) include CE2021 (of Daicel Co., Ltd.), and those of the compound (24) include LS7970 (of Shin-Etsu Chemical Co., Ltd.). CE2080, CE3000, CE2000, Epolead GT300,

Epolead GT400 and EHPE3150 (of Daicel Chemical Industries, Ltd.), YL7170 and YL8034 (of Japan Epoxy Resin Co. , Ltd.) and W-1000 (of Shin Nippon Rika Co., Ltd.) may also be used.

The process of preparing the optical semiconductor sealing compositions [I], [II] and [III] is not particularly limited. These compositions can be prepared by mixing together all the components in accordance with the conventionally known method. As a preferred process of preparing the optical semiconductor sealing composition [I], a polyorganosiloxane (A) obtained by hydrolyzing/condensing the silane compound (1), etc. and the silane compound (2), etc. as described above is mixed with a carboxylic anhydride (B1). As a preferred process of preparing the optical semiconductor sealing composition [II], a polyorganosiloxane (A) obtained by hydrolyzing/condensing the silane compound (1), etc. and the silane compound (2), etc. as described above is mixed with a carboxylic anhydride (B1) and a curing accelerator (C).

Further, the process of preparing the optical semiconductor sealing composition [III] is not particularly limited, and the optical semiconductor sealing composition [III] can be prepared by mixing together all the components in accordance with the conventionally known method.

As a preferred process of preparing the optical semiconductor sealing composition [III], a polyorganosiloxane (A) obtained by hydrolyzing/condensing the silane compound (1), etc. and the silane compound (2), etc. under heating in the presence of an organic solvent, an organic base and water is mixed with a thermal acid generator (B2).

The optical semiconductor sealing composition [I] may be obtained by preparing a polyorganosiloxane solution consisting essentially of the component (A) and a curing agent solution consisting essentially of the component (B1) separately and mixing them together at the time of use. The optical semiconductor sealing composition [II] may be obtained by preparing a polyorganosiloxane solution consisting essentially of the component (A) and a curing agent solution consisting essentially of the component (B1) and the component (C) separately and mixing them together at the time of use.

<u>optical semiconductor sealer</u>

The optical semiconductor sealer of the present invention is a cured product obtained by curing the optical semiconductor sealing composition [I], [II] or [III] by heating.

To form the optical semiconductor sealer of the present invention, the optical semiconductor sealing composition is applied to a predetermined portion of a substrate having an optical semiconductor layer by coating, potting or impregnation and cured by heating.

As means of applying the optical semiconductor sealing composition, which is not particularly limited, a known technique such as coating with a dispenser, potting, coating by screen printing under vacuum or normal pressure, or reaction injection molding may be employed.

As means of curing the optical semiconductor sealing composition after application, which is not particularly limited, a conventionally known curing apparatus such as a closed curing furnace or tunnel furnace capable of continuous curing may be used.

As means of heating for curing, which is not particularly limited, a conventionally known heating technique such as hot air circulation type heating, infrared heating or high-frequency heating may be employed.

As for preferred curing conditions, the curing temperature is 80 to 250°C and the curing time is 30 seconds to 15 hours. In order to reduce the internal stress of the cured product produced by curing, it is preferred that the optical semiconductor sealing composition should be pre-cured at 80 to 120°C for 0.5 to 5 hours and post-cured at 120 to 180°C for 0.1 to 15 hours. In order to cure the optical semiconductor sealing composition in a short time, it is preferred that the optical semiconductor sealing composition should be cured at 150 to 250°C for 30 seconds to 30 minutes.

<u>optical semiconductor</u>

The optical semiconductor of the present invention is an optical semiconductor sealed by the optical semiconductor sealer of the present invention.

In order to obtain the optical semiconductor of the present invention, an optical semiconductor sealer obtained from the optical semiconductor sealing composition [I], an optical semiconductor sealer obtained from the optical semiconductor sealing composition [II] and an optical semiconductor sealer obtained from the optical semiconductor sealing composition [III] may be used in combination.

The film thickness of the optical semiconductor sealer in the optical semiconductor of the present invention is preferably 0.05 mm or more, more preferably 0.1 mm or more. The upper limit of thickness of the optical semiconductor sealer is suitably selected according to the application purpose of an optical semiconductor to be sealed.

The polyorganosiloxane ($\alpha$) of the present invention can be extremely advantageously used as the main component of the optical semiconductor sealing compositions [I], [II] and [III] of the present invention.

The optical semiconductor sealing compositions [I], [II] and [III] of the present invention which comprise the

polyorganosiloxane (A) as the main component can be molded by potting, are free from the cracking or foaming of a cured product obtained therefrom even when it has a large film thickness, can provide an achromatic transparent optical semiconductor sealer having excellent UV resistance and can be extremely advantageously used to seal a blue LED or white LED having an emission peak wavelength of 500 nm or less, for example.

Examples

The following examples are provided for the purpose of further illustrating the present invention but are in no way to be taken as limiting.

The viscosity, Mw and epoxy equivalent of the polyorganosiloxanes (A) obtained in Synthetic Examples were measured as follows.
Method of measuring viscosity: measured at 25˚C with a TV type viscometer.
Method of measuring Mw: measured at a temperature of 40˚C and a pressure of 68 kgf/cm$^2$ by using the TSKgelGRCXLII column of Tosoh Corporation and tetrahydrofuran as a solvent.
Method of measuring epoxy equivalent:

- potassium iodide aqueous solution -
  This was prepared by dissolving 3.0 g of potassium iodide having a low content of an iodate (0.003 wt% or less) in 5.0 g of distilled water.
- titration of epoxy group -
  1.0 to 1.5 g of each sample (polyorganosiloxane) was injected into a 125 ml conical flask equipped with a Dimroth condenser through a bifurcated tube provided with a reflux unit and a buret and refluxed under agitation on a magnetic stirrer with a hot plate, and 20 drops of an indicator and a potassium iodide aqueous solution were added right after the sample was dissolved. Thereafter, the resulting mixture was refluxed again and titrated to the end point with 1N hydrochloric acid. This end point is a point at which when one drop of 1N hydrochloric acid is added, the solution turns yellow from blue and remains yellow for 1 minute or longer.
- method of calculating epoxy equivalent -
  When the weight of the sample is represented by W (g) and the amount of dropped 1N hydrochloric acid is represented by V (ml), the epoxy equivalent is calculated from the following equation.

$$\text{Epoxy equivalent} = 1000 \times W/V$$

- method of determining the quantities of residual metals -

preparation of sample

10 g or more of a sample was collected in a quartz crucible and ashed in an electric furnace at 600˚C. Thereafter, 0.3 ml of aqua regia was added to the sample and the resulting mixture was dried by heating. After this was repeated twice, 0.1 ml of aqua regia was added again and the resulting mixture was rinsed with water to prepare 10 ml of an aqueous solution.

Measurement

The above sample was measured with an inductive coupling plasma mass spectrograph (ICP-MS). The Perkin Elmer ELAN DRC Plus was used and the above measurement was carried at 1.5 kW. In the case of cobalt and nickel, ammonia gas was blown at a rate of 0.6 ml/min.

Synthetic Example 1

27.24 g of methyltrimethoxysilane (MTMS), 49.28 g of 2-(3,4-epoxycyclohexyl)ethyltrimethoxysilane (ECETS), 12.02 g of dimethyldimethoxysilane (DMDS), 749.2 g of methyl isobutyl ketone (MIBK) and 12.65 g of triethylamine were injected into a reactor equipped with a stirrer, thermometer, dropping funnel and reflux condenser and mixed together at room temperature. Thereafter, 90 g of deionized water was added dropwise to the resulting mixture from the dropping funnel over 30 minutes and mixed under reflux to carry out a reaction at 80 ˚C for 4 hours. After the end of the reaction, an organic layer was collected and rinsed with a 0.2 wt% aqueous solution of ammonium nitrate until water after rinsing became neutral, and the solvent and water were distilled off under reduced pressure to obtain a polyorganosiloxane (A)

as a viscous transparent liquid.

When this polyorganosiloxane (A) was analyzed by $^1$H-NMR, a peak attributed to the epoxy group was obtained at a chemical shift (δ) of about 3.2 ppm based on theoretical intensity. It was confirmed that the side-reaction of the epoxy group did not occur during the reaction.

The viscosity, Mw and epoxy equivalent of this polyorganosiloxane (A) are shown in Table 1.

Synthetic Examples 2 to 4

Polyorganosiloxanes (A) were obtained as viscous transparent liquids in the same manner as in Synthetic Example 1 except that charged raw materials shown in Table 1 were used.

The viscosity, Mw and epoxy equivalent of each of the polyorganosiloxanes (A) are shown in Table 1.

Synthetic Example 5

50.0 g of the polymer obtained in Synthetic Example 4 was dissolved in 500 ml of ethyl orthoformate in a reactor equipped with a stirrer, thermometer and reflux condenser and stirred at 130˚C for 1 hour, and volatile matter was distilled off by a vacuum pump so as to obtain a transparent viscous liquid. The liquid had a viscosity of 2 Pa·s, an Mw of 1,300 and an epoxy equivalent of 185. The amounts of the residual metals are shown in Table 2.

Comparative Synthetic Example 1

1,200 g of dioxane and 1 mol of trichlorosilane were charged into a 2-liter four-necked flask equipped with a thermometer, stirring rotor and condenser and stirred. A dropping funnel containing 18 g of water and 18 g of dioxane was attached to the above four-necked flask to add these dropwise while the temperature was maintained at 25 to 30˚C. After addition, the resulting solution was further stirred for 30 minutes, and a dropping funnel containing 3 mol of ethanol was attached to the flask to add ethanol dropwise while the temperature was maintained at 25 to 30˚C. Thereafter, the resulting solution was further stirred for 120 minutes. When the reaction solution was taken out and the solvent was distilled off at about 60˚C or less under reduced pressure, 75.5 g of a low-viscosity liquid was obtained. It had a weight average molecular weight of 1, 600.

Comparative Synthetic Example 2

0.32 g of an isopropanol solution containing 8 % of chloroplatinic acid, 30.0 g of allyl glycidyl ether and 50.8 g of toluene were charged into a 200-ml four-necked flask equipped with a thermometer, stirring rotor, condenser and nitrogen feed pipe. 20.0 g of the liquid prepared in Comparative Synthetic Example 1 was injected into a dropping funnel which was then attached to the above four-necked flask. The above mixture was heated and stirred while nitrogen was blown, and the liquid of Comparative Synthetic Example 1 was added dropwise while the temperature was maintained at 80 to 85˚C after the inside temperature became 70˚C. After the end of addition, the resulting solution was stirred at 80 to 85˚C for 3 hours. When the solvent was distilled off at 50˚C or lower under reduced pressure after the end of a reaction, a colored liquid was obtained. It had a weight average molecular weight of 2,000 and an epoxy equivalent of 220 g/mol.

Although a polysiloxane containing an epoxy group can be synthesized by this method, there are problems that trichlorosilane which is difficult to handle is used and that two-stage synthesis is required.

Table 1

| | Charged raw materials (g) | | | | Viscosity (Pa·S) | Mw | Epoxy equivalent (g/mol) |
|---|---|---|---|---|---|---|---|
| | MTMS | ECETS | DMDS | MIBK | | | |
| Synthetic Example 1 | 27.24 | 49.28 | 12.02 | 749.3 | 300 | 3,000 | 282 |
| Synthetic Example 2 | 13.63 | 73.91 | 12.02 | 995.6 | 80 | 2,200 | 224 |
| Synthetic Example 3 | - | 98.55 | 12.02 | 1,105.7 | 30 | 1,600 | 196 |
| Synthetic Example 4 | - | 123.20 | - | 1,232.0 | 4 | 1,200 | 177 |

Table 2

| | Platinum (ppm) | Rhodium (ppm) | Ruthenium (ppm) | Cobalt (ppm) | Palladium (ppm) | Nickel (ppm) |
|---|---|---|---|---|---|---|
| Synthetic Example 1 | 1 or less | 0.1 or less | 2 or less | 1 or less | 1 or less | 4 or less |
| Synthetic Example 2 | 1 or less | 0.1 or less | 2 or less | 1 or less | 1 or less | 4 or less |
| Synthetic Example 3 | 1 or less | 0.1 or less | 2 or less | 1 or less | 1 or less | 4 or less |
| Synthetic Example 4 | 1 or less | 0.1 or less | 2 or less | 1 or less | 1 or less | 4 or less |
| Synthetic Example 5 | 1 or less | 0.1 or less | 2 or less | 1 or less | 1 or less | 4 or less |
| Comparative Synthetic Example 2 | 1,100 | 0.1 or less | 2 or less | 1 or less | 1 or less | 4 or less |

The molding jig and curing conditions of the optical semiconductor sealing composition and the evaluation methods of the appearance, UV resistance and hardness of its cured product are given below.
Molding jig: Two glass sheets having a polyethylene terephthalate film on the surface were opposed to each other, and a silicon rubber rod having a diameter of 5 mm was bent like letter U and sandwiched between the end portions of the glass sheets to manufacture a molding jig.
Curing conditions 1: The optical semiconductor sealing composition was injected into the above molding jig and heated in an oven set at 140°C for 2 hours to be cured.
Curing conditions 2: The optical semiconductor sealing composition was injected into the above molding jig and heated in an oven set at 100°C for 2 hours, an oven set at 120°C for 2 hours and an oven set at 140°C for 2 hours to be cured.
Evaluation of appearance: The existence of a crack and cell of the cured product was visually checked for evaluation.
Evaluation of UV resistance: The cured product was exposed to ultraviolet light (UV) at 63°C for 2 weeks continuously with an ultraviolet long-life fade meter (of Suga Test Instruments Co., Ltd.) so as to measure its transmittance at a wavelength of 360 nm before and after exposure with a spectrophotometer.
Evaluation of hardness: This was measured with a Shore D hardness meter.
Evaluation of tackiness: This was evaluated by touching with hands.
○: not sticky
× : sticky
heat resistance: The initial transmittance and the transmittance at 470 nm of the cured product after it was left in an oven set at 150°C for 72 hours were measured.

$$\text{(retention)} = \text{(transmittance after heat resistance test)}/\text{(initial transmittance)} \times 100\ (\%)$$

○: retention is 80 % or more
×: retention is less than 80 %

Example 1

10.0 g of the polyorganosiloxane (A) obtained in Synthetic Example 1 as the component (A), 5.5 g of methylhexahydrophthalic anhydride (see the above formula (3), trade name of MH700, manufactured by New Japan Chemical Co. , Ltd.) as the component (B1) and 0.055 g of 2-ethyl-4-methylimidazole (trade name of 2E4MZ, manufactured by Shikoku Kasei Co., Ltd.) as the component (C) were added and mixed together uniformly, and the resulting mixture was defoamed and injected into a molding jig to be cured, thereby obtaining an achromatic transparent cured product without a crack or cell. The evaluation results of this cured product are shown in Table 4.

Examples 2 to 16

Cured products were obtained in the same manner as in Example 1 except that components shown in Table 3 were used. The evaluation results of the cured products are shown in Table 4.

Comparative Examples 1 to 3

Cured products were obtained in the same manner as in Example 1 except that components shown in Table 3 were used. The evaluation results of the cured products are shown in Table 4.

Components other than the above components in Table 3 are given below.

HNA-100 (trade name, manufactured by New Japan Chemical Co., Ltd.): compound represented by the above formula (5)

4XPET: tetra-n-butylphosphonium o,o-diethylphosphorodithionate (trade name: Hisicoline 4X-PET, manufactured by The Nippon Chemical Industrial Co., Ltd.)

HBE100 (trade name, manufactured by New Japan Chemical Co. , Ltd.): compound represented by the following formula.

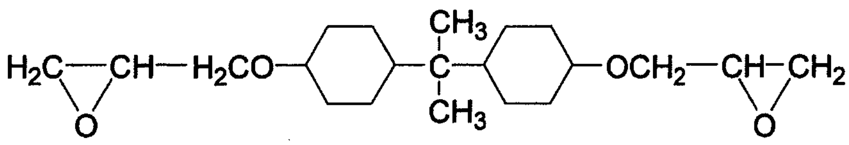

CE2021 (trade name, manufactured by Daicel Chemical Industries, Ltd.): compound represented by the following formula

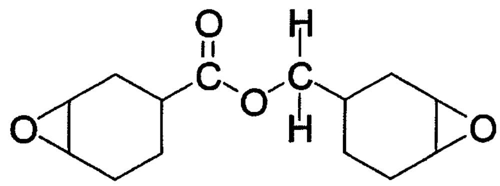

Table 3

| | Component (A) (g) | Component (B) (g) | Component (C) (g) | Alicyclic epoxy compound (g) |
|---|---|---|---|---|
| Ex.1 | Sythetic Example 1 (10) | MH700(5.5) | 2E4MZ(0.055) | - |
| Ex.2 | Sythetic Example 2 (10) | MH700(6.7) | 2E4MZ(0.067) | - |
| Ex.3 | Sythetic Example 3 (10) | MH700(7.7) | 2E4MZ(0.077) | - |
| Ex.4 | Sythetic Example 4 (10) | MH700(8.5) | 2E4MZ(0.085) | - |
| Ex.5 | Sythetic Example 1 (10) | MH700(5.5) | 4XPET(0.055) | - |
| Ex.6 | Sythetic Example 2 (10) | MH700(6.7) | 4XPET(0.067) | - |
| Ex.7 | Sythetic Example 3 (10) | MH700(7.7) | 4XPET(0.077) | - |
| Ex.8 | Sythetic Example 4 (10) | MH700(8.5) | 4XPET(0.085) | - |
| Ex.9 | Sythetic Example 1 (10) | MH700(5.5) | - | - |
| Ex.10 | Sythetic Example 2 (10) | MH700(6.7) | - | - |
| Ex.11 | Sythetic Example 3 (10) | MH700(7.7) | - | - |
| Ex.12 | Sythetic Example 4 (10) | MH700(8.5) | - | - |
| Ex.13 | Sythetic Example 1 (10) | HNA-100(5.9) | 4XPET(0.059) | - |
| Ex.14 | Sythetic Example 2 (10) | HNA-100(7.2) | 4XPET(0.072) | - |

(continued)

| | Component (A) (g) | Component (B) (g) | Component (C) (g) | Alicyclic epoxy compound (g) |
|---|---|---|---|---|
| Ex.15 | Sythetic Example 3 (10) | HNA-100(8.3) | 4XPET(0.083) | - |
| Ex.16 | Sythetic Example 4 (10) | HNA-100(9.2) | 4XPET(0.092) | - |
| C.Ex.1 | - | MH700(9.0) | 2E4MZ(0.090) | HBE100(9.0) CE2021(1.0) |
| C.Ex.2 | - | MH700(9.0) | 4XPET(0.090) | HBE100(9.0) CE2021(1.0) |
| C.Ex.3 | - | MH700(9.0) | - | HBE100(9.0) CE2021(1.0) |
| Ex.: Example<br>C.Ex.: Comparative Example | | | | |

Table 4

| | Curing conditions 1 | | | | | Curing conditions 2 | | | | |
|---|---|---|---|---|---|---|---|---|---|---|
| | Appearance | | UV resistance(%) | | Hardness | Appearance | | UV resistance(%) | | Hardness |
| | Crack | Cell | Before exposure | After exposure | | Crack | Cell | Before exposure | After exposure | |
| Ex. 1 | Not seen | Not seen | 82 | 82 | 87 | Not seen | Not seen | 83 | 82 | 88 |
| Ex. 2 | Not seen | Not seen | 80 | 80 | 90 | Not seen | Not seen | 82 | 82 | 91 |
| Ex. 3 | Not seen | Not seen | 79 | 79 | 90 | Not seen | Not seen | 79 | 79 | 92 |
| Ex. 4 | Not seen | Not seen | 78 | 77 | 89 | Not seen | Not seen | 79 | 78 | 90 |
| Ex. 5 | Not seen | Not seen | 90 | 89 | 84 | Not seen | Not seen | 91 | 91 | 86 |
| Ex. 6 | Not seen | Not seen | 89 | 89 | 88 | Not seen | Not seen | 90 | 89 | 89 |
| Ex. 7 | Not seen | Not seen | 87 | 87 | 88 | Not seen | Not seen | 88 | 87 | 89 |
| Ex. 8 | Not seen | Not seen | 86 | 85 | 87 | Not seen | Not seen | 86 | 86 | 89 |
| Ex. 9 | Not seen | Not seen | 92 | 92 | 85 | Not seen | Not seen | 91 | 91 | 86 |
| Ex. 10 | Not seen | Not seen | 91 | 91 | 86 | Not seen | Not seen | 91 | 91 | 88 |
| Ex. 11 | Not seen | Not seen | 91 | 91 | 87 | Not seen | Not seen | 90 | 90 | 87 |
| Ex. 12 | Not seen | Not seen | 90 | 90 | 85 | Not seen | Not seen | 90 | 90 | 87 |
| Ex. 13 | Not seen | Not seen | 91 | 90 | 87 | Not seen | Not seen | 92 | 91 | 92 |
| Ex. 14 | Not seen | Not seen | 90 | 89 | 89 | Not seen | Not seen | 91 | 90 | 91 |
| Ex. 15 | Not seen | Not seen | 88 | 87 | 89 | Not seen | Not seen | 90 | 90 | 92 |
| Ex. 16 | Not seen | Not seen | 86 | 85 | 88 | Not seen | Not seen | 88 | 88 | 91 |
| C.Ex. 1 | Seen | Seen | - | - | - | Not seen | Not seen | 69 | 59 | 84 |
| C.Ex. 2 | Seen | Seen | - | - | - | Not seen | Not seen | 75 | 66 | 81 |
| C.Ex. 3 | Not cured | | | | | Not cured | | | | |
| Ex.: Example | | | | | | | | | | |

Examples 17 to 21

Cured products were obtained in the same manner as in Example 1 except that components shown in Table 5 were used, with proviso that curing conditions 2 was used. The evaluation results of the cured products are shown in Table 6.

Table 5

| | Component(A) (g) | Component(B) (g) | Component(C) (g) |
|---|---|---|---|
| Example 17 | Synthetic Example 1 (10) | DEGAN(5.6) | UCAT5003(0.056) |
| Example 18 | Synthetic Example 2 (10) | DEGAN(6.8) | UCAT5003(0.067) |
| Example 19 | Synthetic Example 3 (10) | DEGAN(7.8) | UCAT5003(0.078) |
| Example 20 | Synthetic Example 4 (10) | DEGAN(8.9) | UCAT5003(0.089) |
| Example 21 | Synthetic Example 5 (10) | MH700(8.9) | UCAT5003(0.089) |
| Comparative Example 4 | Comparative Synthetic Example 2(10) | MH700(6.7) | UCAT5003(0.067) |
| DEGAN: (trade name, manufactured by Kyowa Hatsuyuka Co., Ltd.): compound represented by the above formula (8).<br>UCAT5003: phosphorus-based catalyst manufactured by Sun Apro Co., Ltd. | | | |

Example 22

10.0 g of the polyorganosiloxane (A) obtained in Synthetic Example 4 as the component (A), 8.5 g of methylhexahydrophthalic anhydride (see the above formula (3), trade name of MH700, manufactured by New Japan Chemical Co., Ltd.) as the component (B1), 0.085 g of U-CAT5003 (of Sun Apro Co., Ltd.) and 2.0 g of RX300 as the components (C) were added and mixed together uniformly, and the resulting mixture was defoamed and injected into a molding jig to be cured, thereby obtaining an achromatic transparent cured product without a crack or cell. The evaluation results of this cured product are shown in Table 6.

Table 6

| | Crack | Cell | Tackiness | Before exposure | After exposure | Heat resistance | Hardness |
|---|---|---|---|---|---|---|---|
| Example 17 | Not seen | Not seen | ○ | 91 | 90 | ○ | 87 |
| Example 18 | Not seen | Not seen | ○ | 92 | 91 | ○ | 82 |
| Example 19 | Not seen | Not seen | ○ | 90 | 90 | ○ | 80 |
| Example 20 | Not seen | Not seen | ○ | 91 | 91 | ○ | 80 |
| Example 21 | Not seen | Not seen | ○ | 90 | 90 | ○ | 90 |
| Example 22 | Not seen | Not seen | ○ | 90 | 90 | ○ | 92 |

Examples 1 to 16 were evaluated as ○ in terms of tackiness and heat resistance.

Comparative Example 4

A cured product was obtained in the same manner as in Example 1 except that components shown in Table 5 were used. Although the cured product had no crack and no cell, it was evaluated as × in terms of heat resistance.

Example 23

10.0 g of the polyorganosiloxane (A) obtained in Synthetic Example 1 as the component (A) and 0.1 g of the compound (17) (trade name of CP77, manufactured by Asahi Denka Kogyo K.K.) as the component (B) were added and mixed together uniformly, and the resulting mixture was defoamed and injected into a molding jig to be cured, thereby obtaining an achromatic transparent cured product without a crack or cell. The evaluation results of appearance

and UV resistance of this cured product are shown in Table 7.

Examples 24 to 26 and Comparative Example 5

Cured products were obtained in the same manner as in Example 23 except that components shown in Table 7 were used. The evaluation results of appearance and EV resistance of each of the cured products are shown in Table 7.
HBE100 and CE2021 which are components other than the above in Table 7 are the same as in Table 3.

Table 7

| | Component (A) (g) | Component (B) (g) | Other component (g) | Crack | Cell | Initial | After exposure to UV |
|---|---|---|---|---|---|---|---|
| Example 23 | Synthetic example 1 (10) | CP77(0.1) | - | Not seen | Not seen | transparent | transparent |
| Example 24 | Synthetic example 2 (10) | CP77(0.1) | - | Not seen | Not seen | transparent | transparent |
| Example 25 | Synthetic example 3 (10) | CP77(0.1) | - | Not seen | Not seen | transparent | transparent |
| Example 26 | Synthetic example 4 (10) | CP77(0.1) | - | Not seen | Not seen | transparent | transparent |
| Comparative Example 5 | - | CP77(0.1) | HBE100(9) CE2021(1) | Not seen | Not seen | transparent | colored yellow |

## Claims

1. A polyorganosiloxane having a weight average molecular weight in terms of polystyrene of 500 to 1,000,000 obtained by hydrolyzing/condensing a silane compound represented by the following formula (1) and/or a partial condensate thereof;

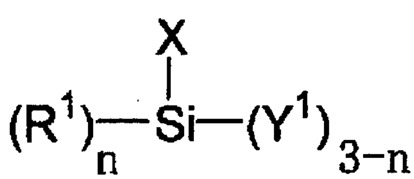

(1)

wherein X is a monovalent organic group having at least one epoxy group, $Y^1$ is a chlorine atom, bromine atom, iodine atom, or linear, branched or cyclic alkoxyl group having 1 to 20 carbon atoms, $R^1$ is a hydrogen atom, fluorine atom, linear, branched or cyclic alkyl group having 1 to 20 carbon atoms, linear, branched or cyclic substituted alkyl group having 1 to 20 carbon atoms, linear, branched or cyclic alkenyl group having 2 to 20 carbon atoms, aryl group having 6 to 20 carbon atoms, or aralkyl group having 7 to 20 carbon atoms, and n is an integer of 0 to 2,
and a silane compound represented by the following formula (2) and/or a partial condensate thereof:

$$(R^2)_m{-}Si{-}(Y^2)_{4-m} \qquad (2)$$

wherein $Y^2$ is a chlorine atom, bromine atom, iodine atom, or linear, branched or cyclic alkoxyl group having 1 to 20 carbon atoms, $R^2$ is a hydrogen atom, fluorine atom, linear, branched or cyclic alkyl group having 1 to 20 carbon atoms, linear, branched or cyclic substituted alkyl group having 1 to 20 carbon atoms, linear, branched or cyclic alkenyl group having 2 to 20 carbon atoms, aryl group having 6 to 20 carbon atoms, or aralkyl group having 7 to 20 carbon atoms, and m is an integer of 0 to 3,
under heating in the presence of an organic solvent, an organic base and water.

**2.** The polyorganosiloxane according to claim 1 which has an epoxy equivalent of 1,600 g/mol or less and contains each of platinum, ruthenium, cobalt, palladium and nickel in amounts of 10 ppm at maximum.

**3.** The polyorganosiloxane according to claim 1, wherein X in the above formula (1) is a monovalent organic group having an epoxycyclohexyl group.

**4.** A process for preparing the polyorganosiloxane of claim 1, comprising the step of hydrolyzing/condensing a silane compound represented by the above formula (1) and/or a partial condensate thereof and a silane compound represented by the above formula (2) and/or a partial condensate thereof under heating in the presence of an organic solvent, an organic base and water.

**5.** An optical semiconductor sealing composition comprising:

(A) the polyorganosiloxane of claim 1 which satisfies at least one of the following conditions (i) and (ii):

(i) the epoxy equivalent is 1,600 g/mol or less, and
(ii) the content of a recurring unit derived from a silane compound represented by the above formula (1) is at least 5 mol% of the total of all the recurring units; and

(B1) a carboxylic anhydride.

**6.** A process for preparing the optical semiconductor sealing composition of claim 5, comprising the step of mixing together the polyorganosiloxane (A) and the carboxylic anhydride (B1).

**7.** An optical semiconductor sealing composition comprising:

(A) the polyorganosiloxane of claim 1 which satisfies at least one of the following conditions (i) and (ii):

(i) the epoxy equivalent is 1,600 g/mol or less, and
(ii) the content of a recurring unit derived from a silane compound represented by the above formula (1) is at least 5 mol% of the total of all the recurring units;

(B1) a carboxylic anhydride; and
(C) a curing accelerator.

**8.** A process for preparing the optical semiconductor sealing composition of claim 7, comprising the step of mixing together the polyorganosiloxane (A), the carboxylic anhydride (B1) and the curing accelerator (C).

**9.** An optical semiconductor sealing composition comprising:

(A) the polyorganosiloxane of claim 1 which satisfies at least one of the following conditions (i) and (ii):

(i) the epoxy equivalent is 1,600 g/mol or less, and
(ii) the content of a recurring unit derived from a silane compound represented by the above formula (1) is at least 5 mol% of the total of all the recurring units; and

(B2) a thermal acid generator.

**10.** A process for preparing the optical semiconductor sealing composition of claim 9, comprising the step of mixing together the polyorganosiloxane (A) and the thermal acid generator (B2).

**11.** An optical semiconductor sealer which is a cured product obtained by curing the optical semiconductor sealing composition of any one of claims 5, 7 and 9 by heating.

**12.** An optical semiconductor sealed by the optical semiconductor sealer of claim 11.

## INTERNATIONAL SEARCH REPORT

International application No.
PCT/JP2005/007493

A. CLASSIFICATION OF SUBJECT MATTER
Int.Cl[7] C08G77/14, 59/20, 59/42, H01L23/29, 23/31

According to International Patent Classification (IPC) or to both national classification and IPC

B. FIELDS SEARCHED

Minimum documentation searched (classification system followed by classification symbols)
Int.Cl[7] C08G77/00-77/62, C08G59/00-59/72, H01L23/29, 23/31, C08L83/00-83/16, C08L63/00-63/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)
WPI/L, CAS ONLINE

C. DOCUMENTS CONSIDERED TO BE RELEVANT

| Category* | Citation of document, with indication, where appropriate, of the relevant passages | Relevant to claim No. |
|---|---|---|
| X<br>A | JP 2003-273098 A (Fujitsu Ltd.), 26 September, 2003 (26.09.03), Claims 1 to 5; Par. No. [0024]; examples 1 to 2 (Family: none) | 1-4<br>5-12 |
| P,X<br>P,A | WO 2004/072150 A1 (Nippon Kayaku Co., Ltd.), 26 August, 2004 (26.08.04), Claims 1 to 14 (Family: none) | 1-4<br>5-12 |
| P,X | JP 2004-359933 A (Nagase Chemtex Corp.), 24 December, 2004 (24.12.04), Claims 1 to 8; preparation example 1 (Family: none) | 1-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>26 July, 2005 (26.07.05) | Date of mailing of the international search report<br>09 August, 2005 (09.08.05) |
| Name and mailing address of the ISA/<br>Japanese Patent Office<br>Facsimile No. | Authorized officer<br><br>Telephone No. |

Form PCT/ISA/210 (second sheet) (January 2004)

INTERNATIONAL SEARCH REPORT

International application No.
PCT/JP2005/007493

C (Continuation). DOCUMENTS CONSIDERED TO BE RELEVANT

| Category* | Citation of document, with indication, where appropriate, of the relevant passages | Relevant to claim No. |
|---|---|---|
| A | JP 4-202325 A (Toray Industries, Inc.), 23 July, 1992 (23.07.92), Claim 1 (Family: none) | 1-12 |
| A | JP 3-47840 A (Shin-Etsu Chemical Co., Ltd.), 28 February, 1991 (28.02.91), Claims 1 to 2 (Family: none) | 1-12 |
| A | JP 6-200032 A (Dow Corning Corp.), 19 July, 1994 (19.07.94), Claims 1 to 8 & US 5280098 A & EP 590954 A2 | 1-12 |
| A | JP 11-92665 A (Dow Corning Toray Silicone Co., Ltd.), 06 April, 1999 (06.04.99), Claims 1 to 3 (Family: none) | 1-12 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003082062 A
- JP 62106632 A
- JP 1297421 A
- JP 2067290 A
- JP 4252228 A
- JP 4352793 A
- JP 8041168 A
- JP 12103859 A